Europäisches Patentamt

European Patent Office

Office européen des brevets

(19)

(11) Numéro de publication: **0 167 198**
**B1**

(12) **FASCICULE DE BREVET EUROPEEN**

(45) Date de publication du fascicule du brevet:
**05.10.88**

(51) Int. Cl.⁴: **C 03 C 8/24**

(21) Numéro de dépôt: **85200960.4**

(22) Date de dépôt: **18.06.85**

(54) **Mélange de départ pour une composition isolante comprenant un verre au plomb, encre sérigraphiable comportant un tel mélange et utilisation de cette encre pour la protection de microcircuits hybrides sur substrat céramique.**

(30) Priorité: **22.06.84 FR 8409809**

(43) Date de publication de la demande:
**08.01.86 Bulletin 86/2**

(45) Mention de la délivrance du brevet:
**05.10.88 Bulletin 88/40**

(84) Etats contractants désignés:
**BE DE FR GB IT NL SE**

(56) Documents cités:
**EP - A - 0 068 565**
**EP - A - 0 084 936**

**CHEMICAL ABSTRACTS, vol. 91, 1979, page 247, no. 144797s, Columbus, Ohio, US; G.I. ARTAMONOVA et al.: "Use of insulating glass in hybrid integrated circuits with an aluminum plating system"**

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **BE DE GB IT NL SE**

(72) Inventeur: **Baudry, Hugues, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

L'invention concerne la formulation d'un mélange de départ pour une composition isolante comprenant d'une part une phase vitreuse formée d'alumine (Al$_2$O$_3$), de silice (SiO$_2$), d'anhydride borique (B$_2$O$_3$) et incluant un monoxyde de plomb (PbO), et d'autre part un ou plusieurs oxydes de plomb à un degré d'oxydation supérieur ou égal à deux sous forme pulvérulente.

L'invention concerne également une encre sérigraphiable formée à partir d'une telle composition.

L'invention concerne enfin un procédé de réalisation d'un microcircuit hybride sur un substrat en céramique, incluant l'emploi de cette encre comme couche supérieure de protection dite «encapsulant».

Il est actuellement connu de réaliser des microcircuits en technologie dite hybride, sur un substrat en céramique, à l'aide de couches sérigraphiées d'encres alternativement conductrices et isolantes. Une encre conductrice sérigraphiable compatible avec un substrat céramique est en particulier connue par le brevet anglais No. 1 489 031 et une encre isolante sérigraphiable compatible avec cette encre conductrice est connue par le brevet US No. 4 152 282. Des éléments discrets tels que des résistances peuvent en outre être réalisés par exemple à l'aide d'une encre résistive telle que connue par le brevet US No. 4 420 338, tous au nom de la Demanderesse.

Mais les circuits réalisés à l'aide de ces encres doivent conserver leurs performances tout au long de leur durée de vie. La protection des composants sérigraphiés et plus particulièrement des résistances, contre les agressions mécaniques ou chimiques provenant de leur environnement est donc nécessaire. Cette protection doit être d'une part compatible avec les matériaux constituant les circuits, et d'autre part en accord avec leur procédé de réalisation. La solution la plus évidente pour réaliser une couche de protection sur un circuit hybride est de concevoir une couche de protection sérigraphiée.

Il faut noter qu'une telle couche de protection nécessite alors une cuisson supplémentaire du circuit sur lequel elle est réalisée. Si les conducteurs et les isolants formant le circuit sont relativement insensibles à une recuisson, puisque leur formulation est prévue pour la réalisation de multicouches, il n'en est pas de même des résistances.

En effet, ces dernières, connues par exemple par le brevet US No. 4 420 338 cité précédemment, sont constituées principalement d'un mélange d'hexaborures métalliques et d'une fritte de verre. La valeur des résistances dépend de la quantité du matériau intergranulaire formé par réaction entre la phase vitreuse et les hexaborures. Cette quantité de matériau est bien sûr très dépendante des conditions de cuisson, c'est-à-dire la durée et la température. Selon les expériences de recuisson qui ont été effectuées sur ces résistances, il apparaît très nettement que les variations des valeurs des résistances, lors d'une recuisson, sont d'autant plus faibles que la température de recuisson est basse.

Afin de limiter autant que possible l'influence d'une telle recuisson sur les éléments de circuits sensibles comme les résistances, l'encre sérigraphiable choisie comme couche d'encapsulation devra en premier lieu présenter une température de cuisson inférieure à 600°C, cette valeur de température étant déterminée comme limite supérieure au cours des expériences effectuées.

D'autre part, pour remplir la fonction de couche d'encapsulation, cette encre devra posséder des propriétés d'étanchéité et former une couche aussi compacte que possible tout en étant électriquement isolante, ce qui se traduit par une conductivité électrique aussi faible que possible.

Enfin cette couche d'encapsulation doit être compatible avec les autres couches conductrices et isolantes réalisées conformément aux documents cités précédemment pour constituer les microcircuits hybrides. Or ces couches possèdent la propriété de pouvoir être cuites sous atmosphère non oxydante de manière à éviter l'oxydation des conducteurs en cuivre. Dans ces conditions, l'encapsulant souhaité doit également posséder la propriété d'être cuit sous atmosphère non oxydante. La composition destinée à former l'encapsulant doit alors contenir elle-même un oxyde capable, par décomposition lors de la cuisson, de fournir l'oxygène indispensable à la combustion du véhicule organique dans lequel est dispersée cette composition évitant ainsi la formation de résidus charbonneux lors de cette opération.

Le problème technique posé est donc le suivant: pour protéger des circuits hybrides réalisés sur un substrat en céramique et tout particulièrement des résistances, il convient de mettre au point une encre sérigraphiable pour encapsulation qui possède comme caractéristiques:
- une faible température de cuisson, très inférieure à 600°C;
- un coefficient de dilatation proche de celui de la céramique;
- une excellente compacité;
- une conductivité électrique aussi faible que possible;
- la possibilité de cuisson sous atmosphère neutre.

Un mélange de départ permettant d'obtenir par dispersion dans un véhicule organique une encre sérigraphiable qui possède comme caractéristique:
- une température de cuisson de 550°C;
- une faible conductivité permettant de l'utiliser comme couche d'isolation électrique;
- la possibilité de cuisson sous atmosphère neutre, est connu de l'art antérieur par le brevet EP-A 268 565 déposé au nom de la Demanderesse.

Ce mélange comprend d'une part une partie vitreuse constituée des proportions molaires des

ce (SiO$_2$) 25 à 45%, l'anhydride borique (B$_2$O$_3$) 0 à 10% et le monoxyde de plomb (PbO) 40 à 60%, et d'autre part des phases céramiques telles que l'aluminate de lanthane (LaAlO$_3$) dans les proportions volumiques de 1 à 10%, et le dioxyde de plomb (PbO$_2$) dans les proportions volumiques de 15 à 1%, la phase vitreuse intervenant alors dans les proportions volumiques d'environ 85%.

Mais l'encre obtenue à partir de ce mélange de départ présente également des propriétés qui la rendent incompatible avec le but que l'on cherche ici à atteindre et en particulier:
– une coefficient de dilatation thermique adapté aux substrats en tôle émaillée donc trop élevé pour un substrat en alumine;
– une vitrification (émaillage) insuffisante due au fait qu'elle a été étudiée pour réaliser une couche électriquement isolante en non une couche d'encapsulation.

C'est pourquoi, dans le but de pallier ces inconvénients et de résoudre le problème technologique posé, la présente invention propose un mélange de départ tel que défini dans le préambule, caractérisé en ce que la phase vitreuse est formée des proportions molaires des oxydes suivants: alumine (Al$_2$O$_3$) 1 à 10%, silice (SiO$_2$) 30 à 45%, anhydride borique (B$_2$O$_3$) 15 à 30%, monoxyde de plomb (PbO) 17 à 30%, anhydride calcique (CaO) 1 à 10%, oxyde de zinc (ZnO) 5 à 15%, oxyde de cuivre (CuO) supérieure à 0% jusqu'à 5% et en ce que cette phase vitreuse représente 95 à 70% du mélange alors que les oxydes de plomb de degré d'oxydation supérieur ou égal à deux représentent 5 à 30% du mélange en volume.

Selon une réalisation particulière de l'invention, ce mélange est remarquable en ce que l'oxyde de degré d'oxydation supérieure ou égal à deux choisi est le dioxyde de plomb (PbO$_2$).

Selon une réalisation préférentielle, ce mélange est remarquable en ce que la phase vitreuse est constituée des proportions molaires des oxydes suivants: alumine (Al$_2$O$_3$) 5%, silice (SiO$_2$) 40%, anhydride borique (B$_2$O$_3$) 20%, monoxyde de plomb (PbO) 22%, anhydride calcique (CaO) 3%, oxyde de zinc (ZnO) 8%, oxyde de cuivre (CuO) 2%.

Enfin selon cette réalisation préférentielle, ce mélange est remarquable en ce que la phase vitreuse représente 75% et le dioxyde de plomb 25% en volume des phases minérales.

Dans ces conditions, l'encre obtenue en dispersant cette composition dans un véhicule organique permet de résoudre le problème technologique posé, du fait qu'elle présente les propriétés suivantes:
– une température de cuisson remarquablement faible de 550°C;
– un coefficient de dilatation adapté à celui de la céramique entre 0°C et la température de cuisson, permettant d'éviter les retraits et les déformations lors du refroidissement;
– une très bonne étanchéité;
– une très faible conductivité;
– la possibilité de cuissons sous azote;
– une cœfficient de dilatation thermique adapté suel après cuisson et l'ajustage par laser des résistances.

La description suivante, en s'appuyant sur les figures annexées fera mieux comprendre comment l'invention est réalisée.
– La figure 1 représente en coupe un microcircuit incluant une couche d'encapsulation selon l'invention.
– La figure 2 représente en coupe une résistance incluant une couche d'encapsulation selon l'invention.

Selon la présente invention, un mélange de départ pour une encre sérigraphiable destinée à remplir la fonction d'encapsulation est donc formée d'un verre au plomb, auquel est ajouté (sont ajoutés) un (ou plusieurs) oxyde(s) de plomb à un degré d'oxydation égal ou supérieur à deux sous forme pulvérulente.

Dans une réalisation préférentielle, on utilisera le dioxyde de plomb (PbO$_2$) associé à une fritte de verre réalisée à l'aide des oxydes suivants dont les proportions sont données dans le tableau I.

### Tableau I

Phase vitreuse: En proportions molaires

|  | Composition | Composition préférentielle |
|---|---|---|
| PbO | 17 à 30% | 22% |
| SiO$_2$ | 30 à 45% | 40% |
| B$_2$O$_3$ | 15 à 30% | 20% |
| Al$_2$O$_3$ | 1 à 10% | 5% |
| CaO | 1 à 10% | 3% |
| ZnO | 5 à 15% | 8% |
| CuO | 0 à 5% | 2% |

Melange de depart: En proportions volumiques

|  | Composition | Composition préférentielle |
|---|---|---|
| Verre précédent broyé | 95 à 70% | 75% |
| PbO$_2$ pulvérulent | 5 à 30% | 25% |

Composition du vehicule organique: En poids

Ethyl cellulose 5%

Terpinéol<br>Acétate de butyl-carbitol } 95%<br>Dibutyl phtalate

Comme il était connu de l'art antérieur cité, l'utilisation de l'oxyde de plomb (PbO) dans la formation de la phase vitreuse permet d'obtenir une diminution du point de fusion de verre, donc de la température de cuisson de l'encre. Selon le document cité, avec des proportions de 40 à 60% en moles de PbO dans la phase vitreuse, cette phase vitreuse représentant ensuite 85% en volume du mélange, lequel inclut en outre 5 à 15% de dioxyde de plomb qui participent à atteindre le même but, on arrivait à abaisser le point de cuisson de l'encre jusqu'à 550°C.

Cette température est certes adéquate pour résoudre le problème technologique posé. Mais les proportions d'oxydes de plomb très élevées qui ont permis de diminuer la température, ont d'un autre côté provoqué en même temps l'apparition d'un fort cœfficient de dilatation des couches réalisées à l'aide de ce mélange.

Or on cherche précisément à diminuer ce cœfficient de dilatation. En effet, l'encre réalisée selon l'enseignement du document cité était adaptée à un substrat en tôle émaillé, alors que l'encre selon la présente invention doit être adaptée à un substrat en céramique dont le cœfficient de dilatation est bien inférieur.

Ces difficultés sont résolues, selon la présente invention, par l'adjonction dans la phase vitreuse de trois modificateurs qui sont l'anhydride calcique (CaO), l'oxyde de zinc (ZnO) et l'oxyde de cuivre (CuO). Ces oxydes vont permettre, non seulement de ne pas augmenter les proportions des oxydes de plomb, mais encore de les diminuer par rapport à ce qui était préconisé par le document cité, tout en obtenant à la fois la très faible température de cuisson et le cœfficient de dilatation souhaité. On notera que l'oxyde de cuivre fournit l'avantage supplémentaire de colorer l'émail en vert, permettant ainsi d'obtenir une meilleure absorption de l'énergie des faisceaux lasers utilisés pour la découpe des substrats en céramique en fin de réalisation des circuits. On notera enfin que les couches réalisées à l'aide de l'encre préparée à partir de ce mélange présentent une excellente compacité et une parfaite étanchéité.

Cependant une difficulté supplémentaire reste encore à résoudre du fait que lorsqu'un verre au plomb est utilisé pour constituer une encre, cette dernière ne supporte pas la cuisson sous atmosphère neutre comme par exemple l'azote, car elle se décompose rapidement, cette décomposition provenant de la réduction de l'oxyde de plomb (PbO) à des températures de l'ordre de 450°C. Le document cité préconise l'adjonction d'oxydes à un degré d'oxydation supérieur à deux par exemple du dioxyde de plomb (PbO$_2$) sous forme pulvérulente, qui en libérant de l'oxygène au moment de la cuisson, permet d'éviter la réduction du monoxyde de plomb (PbO) contenu dans la phase vitreuse et de brûler le véhicule organique sans laisser de résidus charbonneux.

Mais les oxydes de plomb de degré d'oxydation supérieur ou égal à deux, qui sont incorporés au mélange sous forme pulvérulente, sont dissous par la phase vitreuse sous forme de monoxyde de plomb (PbO) lors de la cuisson, risquant de détruire l'équilibre prévu entre la valeur de la température de cuisson et la valeur du cœfficient de dilatation.

A cet effet, en proposant pour les constituants du mélange, les proportions dont les valeurs sont réunies dans le tableau I, la présente invention permet de résoudre efficacement tous les problèmes posés à la fois.

Un procédé de réalisation d'une encre selon l'invention est fourni ici à titre d'exemple.

Une des compositions vitreuses dont les proportions sont données dans le tableau I, est broyée 64 heures au broyeur à rouleaux, et intimement mélangée au dioxyde de plomb (PbO$_2$) dans les proportions également données dans le même tableau I. Après filtrage et séchage, le mélange de poudres obtenu est dispersé dans le véhicule organique dont la composition préférentielle est encore donnée dans le tableau I.

L'encre ainsi réalisée est ensuite sérigraphiée en dernière couche de recouvrement de circuits hybrides sur substrat céramique, ou en couche d'encapsulation de résistances réalisées à l'aide d'encres aux hexaborures, ou en couche d'encapsulation d'autres éléments également sur substrat en céramique.

Cette couche d'encapsulation est ensuite cuite au four à passage à 550°C sous azote (10 mn de palier avec des cycles de l'heure).

En ce qui concerne les résistances par exemple, l'utilisation de cet encapsulant conduit à des dérives d'environ:
0,03% pour 1 kΩ$\square^{-1}$, pouvant aller jusqu'à:
3% pour 100 kΩ$\square^{-1}$, ce qui est considéré comme tout à fait accepable.

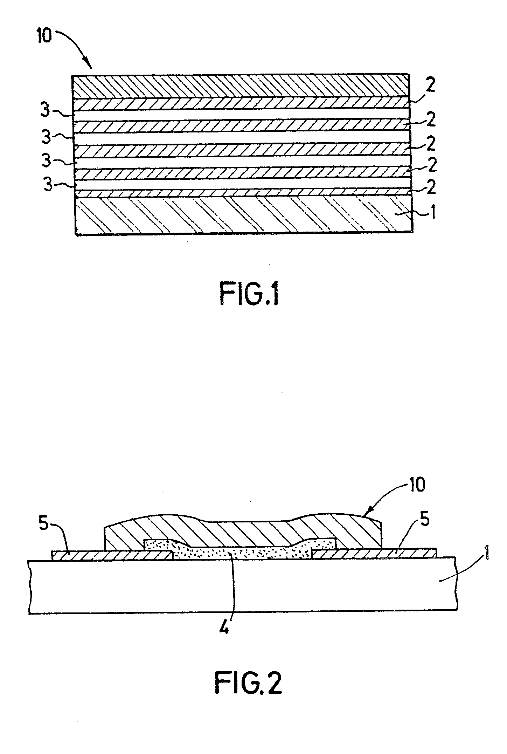

La figure 1 montre un exemple d'utilisation de cette encre comme encapsulant.

Sur un substrat en alumine 1 est réalisé un circuit comprenant par exemple une succession de couches alternativement conductrices 2 et isolantes 3, réalisées à l'aide de masques à travers des écrans de sérigraphie, selon un schéma électrique d'interconnexion prédéterminé. Le nombre des couches conductrices peut s'élever jusqu'à 5. Les matériaux utilisés pour réaliser ces couches sont conformes aux brevets cités d'encre conductrices et isolantes. La dernière couche déposée 10 est la couche d'encapsulation selon l'invention.

La figure 2 représente un second exemple d'utilisation de cette encre comme encapsulant.

Sur un substrat en alumine 1, est déposée, selon un schéma approprié à former des contacts électrique 5, une couche sérigraphiée d'une encre conductrice citée. Cette couche est cuite à une température élevée, en général de l'ordre de 850 à 900°C. Puis une couche 4 d'encre aux hexaborures est déposée par sérigraphie, selon le schéma préalablement défini pour former la résistance, cette couche débordant sur les contacts électriques 5. Cette couche 4 est cuite à une température de l'ordre de 800°C. Enfin une couche 10 d'encre pour encapsulation selon la présente invention est réalisée en surface sur l'ensemble, à l'exception des extrémités des conducteurs électriques, de manière à ménager une plage pour les prises de contact. Après cuisson de cette dernière couche 10 dans les conditions décrites précédemment, la résistance peut être ajustée à l'aide d'un faisceau laser, à travers la couche d'encapsulation, puis le substrat en alumine peut être découpé également par laser sur la périphérie de cette résistance de manière à constituer un élément discret.

**Revendications**

1. Mélange· de départ pour une composition isolante comprenant d'une part une phase vitreuse formée d'alumine (Al₂O₃), de silice (SiO₂), d'anhydride borique (B₂O₃) et incluant un monoxyde de plomb (PbO), et comprenant d'autre part un ou plusieurs oxydes de plomb à un degré d'oxydation supérieur ou égal à deux sous forme pulvérulente, caractérisé en ce que la phase vitreuse est formée des proportions molaires des oxydes suivants: alumine (Al₂O₃) 1 à 10%, silice (SiO₂) 30 à 45%, anhydride borique (B₂O₃) 15 à 30%, monoxyde de plomb (PbO) 17 à 30%, anhydride calcique (CaO) 1 à 10%, oxyde de zinc (ZnO) 5 à 15%, oxyde de cuivre (CuO) supérieure à 0% jusqu'à 5% et en ce que cette phase vitreuse représente 95 à 70% du mélange alors que les oxydes de plomb de degré d'oxydation supérieur ou égal à deux représentent 5 à 30% du mélange en volume.

2. Mélange selon la revendication 1, caractérisé en ce que la phase vitreuse est formée des proportions molaires des oxydes suivants: alumine (Al₂O₃) 5%, silice (SiO₂) 40%, anhydride borique (B₂O₃) 20%, monoxyde de plomb (PbO) 22%, anhydride calcique (CaO) 3%, oxyde de zinc (ZnO) 8%, oxyde de cuivre (CuO) 2%.

3. Mélange selon l'une des revendications 1 ou 2, caractérisé en ce que les oxydes de degré d'oxydation supérieur ou égal à deux sont constitués par le dioxyde de plomb (PbO₂).

4. Mélange selon la revendication 3 dans la mesure où cette dernière dépend de la revendication 2, caractérisé en ce que la phase vitreuse représente 75% en volume et le dioxyde de plomb 25%.

5. Encre sérigraphiable constituée d'un mélange selon l'une quelconque des revendications 1 à 4, incorporé dans un véhicule organique tel qu'une solution d'éthyl cellulose dans du terpinéol.

6. Procédé de réalisation d'un microcircuit hybride réalisé sur substrat en alumine, caractérisé en ce qu'une encre selon la revendication 5 est déposée par sérigraphie à la surface de ce circuit et cuite à une température de palier de 550° pendant au moins 5 mn, pour former une couche de protection.

**Patentansprüche**

1. Ausgangsmischung für eine isolierende Zusammensetzung, die einerseits eine Glasphase aufweist, die durch Aluminiumoxid (Al₂O₃), Siliziumdioxid (SiO₂), Boranhydrid (B₂O₃) mit Bleimonoxid (PbO) gebildet wird und andererseits ein oder mehrere pulverförmige Bleioxide aufweist mit einem Oxydationsgrad, der höher ist als zwei oder gleich zwei ist, dadurch gekennzeichnet, dass die Glasphase durch die folgenden Molverhältnisse der Oxide gebildet wird: Aluminiumoxid (Al₂O₃)1 bis 10%, Siliziumdioxid (SiO₂) 30 bis 45%, Boranhydrid (B₂O₃) 15 bis 30%, Bleimonoxid (PbO) 17 bis 30%, Calciumanhydrid (CaO) 1 bis 10%, Zinkoxid (ZnO) 5 bis 15%, Kupferoxid (CuO) mehr als 0% und weniger als 5% und dass diese Glasphase 95 bis 70% der Mischung darstellt, während die Bleioxide mit einem Oxydationsgrad grösser als oder gleich zwei 5 bis 30 Volumenprozent der Mischung darstellen.

2. Mischung nach Anspruch 1, dadurch gekennzeichnet, dass die Glasphase durch die Molverhältnisse der folgenden Oxide gebildet wird: Aluminiumoxid (Al₂O₃) 5%, Siliziumdioxid (SiO₂) 40%, Boranhydrid (B₂O₃) 20%, Bleimonoxid (PbO) 22%, Calciumanhydrid (CaO) 3%, Zinkoxid (ZnO) 8%, Kupferoxid (CuO) 2%.

3. Mischung nach einem der Ansprüche 1 oder 2, dadurch gekennzeichnet, dass die Oxide mit einem Oxydationsgrad grösser als oder gleich zwei durch Bleidioxid (PbO₂) gebildet werden.

4. Mischung nach Anspruch 3 in dem Masse, in dem dieser vom Anspruch 2 abhängig ist, dadurch gekennzeichnet, dass die Glasphase 75 Volumenprozent und das Bleioxid 25 Volumenprozent darstellt.

5. Siebdrucktinte mit einer Mischung nach einem der Ansprüche 1 bis 4 in einem organischen Träger, wie einer Lösung von Äthylzellulose in Terpineol.

6. Verfahren zum Herstellen einer hybriden Mikroschaltung auf einem Substrat aus Aluminiumoxid, dadurch gekennzeichnet, dass eine Tinte nach Anspruch 5 im Siebdruckverfahren auf der Oberfläche dieser Schaltung angebracht und zum Bilden einer Schutzschicht während mindestens 5 Minuten bei einer Zwischenphasentemperatur von 550°C gebrannt wird.

**Claims**

1. A starting mixture for an isolating composition containing on the one hand a vitreous phase formed by alumina (Al₂O₃), silica (SiO₂), boric oxide (B₂O₃) and including lead monoxide (PbO), and on the other hand one or several lead oxides in powder form having a degree of oxidation higher than or equal to two, characterized in that the vitreous phase is constituted by molar ratios of the following oxides: alumina (Al₂O₃) 1 to 10%, silica (SiO₂) 30 to 45%, oxide (ZnO), calcium oxide (CaO) and copper oxide (CuO), boric oxide (B₂O₃) 15 to 30%, lead monoxide (PbO) 17 to 30%, calcium oxide (CaO) 1 to 10%, zinc oxide (ZnO) 5 to 15%, copper oxide (CuO) more than 0% and less than 5% and in that said vitreous phase represents 95 to 70% of the mixture while the lead oxides having a degree of oxidation higher than or equal to two represent 5 to 30% of the mixture by volume.

2. A mixture as claimed in Claim 1, characterized in that the vitreous phase is formed by molar ratios of the following oxides: alumina (Al₂O₃) 5%, silica (SiO₂) 40%, boric oxide (B₂O₃) 20%, lead monoxide (PbO) 22%, calcium oxide (CaO) 3%, zinc oxide (ZnO) 8%, copper oxide (CuO) 2%.

3. A mixture as claimed in one of the Claims 1 or 2, characterized in that the oxides having a degree of oxidation higher than or equal to two are formed by lead dioxide ($PbO_2$).

4. A mixture as claimed in Claim 3, in so far as the latter is appendant to Claim 2, characterized in that the vitreous phase represents 75% by volume and the lead dioxide 25% by volume.

5. A screen printing ink formed by a mixture as claimed in any one of the Claims 1 to 4, incorporated in an organic carrier, for example, an ethyl cellulose solution in terpineol.

6. A method of producing a hybrid microcircuit provided on a substrate of alumina, characterized in that an ink as claimed in Claim 5 is applied by silk-screening on the surface of said circuit and is fired at a temperature of 550°C which is constant for at least 5 minutes to form a protective layer.

FIG.1

FIG.2